# EUROPEAN PATENT APPLICATION

(11) **EP 2 500 930 A1**
(43) Date of publication of application: **19.09.2012**
(21) Application number: 10828383.9
(22) Date of filing: 08.11.2010
(51) Int. Cl.: H01L 21/308, H01L 21/306, H01L 21/3205, H01L 23/52

(54) **ETCHING LIQUID FOR ETCHING SILICON SUBSTRATE REAR SURFACE IN THROUGH SILICON VIA PROCESS AND METHOD FOR MANUFACTURING SEMICONDUCTOR CHIP HAVING THROUGH SILICON VIA USING THE ETCHING LIQUID**

(30) Priority: 09.11.2009 JP 2009256437
(71) Applicant: Mitsubishi Gas Chemical Company, Inc., Tokyo 100-8324 (JP)
(72) Inventor: SOTOAKA, Ryuji, Tokyo 125-0051 (JP); FUJIOTO, Yoshiko, Tokyo 125-0051 (JP)
(74) Representative: Müller-Boré & Partner Patentanwälte
(86) International application number: PCT/JP2010/069864
(87) International publication number: WO 2011/055825

(57) **Abstract**

Disclosed are an etching liquid which is used for etching a silicon substrate rear surface in a through silicon via process, etches only a silicon substrate without etching a connecting plug composed of a metal such as copper, tungsten, etc., or polysilicon or the like, and has an excellent etching rate; and a method for manufacturing a semiconductor chip having a through silicon via using the same. The etching liquid is an etching liquid for etching a silicon substrate rear surface in a through silicon via process containing potassium hydroxide, hydroxylamine, and water; and the method for manufacturing a semiconductor chip includes a silicon substrate rear surface etching step using the etching liquid.

## Description

### TECHNICAL FIELD

The present invention relates to an etching liquid for etching a silicon substrate rear surface in a through silicon via process and a method for manufacturing a semiconductor chip having a through silicon via using the same.

### BACKGROUND ART

In recent years, following the requirements for downsizing of electronic appliances, downsizing, high integration and multi-functionalization of semiconductor devices to be used for the electronic appliances are being rapidly advanced, and in order to realize such, there have been developed three-dimensional multi-chip semiconductor devices which are manufactured by stacking semiconductor chips.

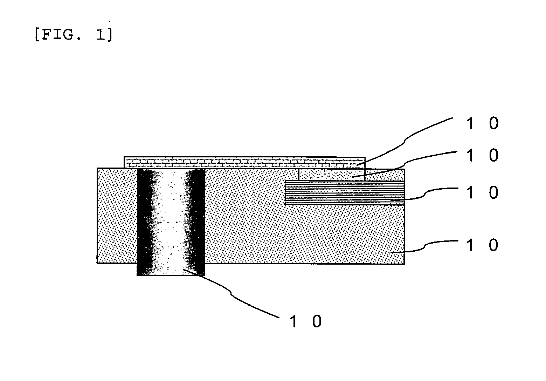

Among semiconductor chips which are used for three-dimensional multi-chip semiconductor devices, for example, a semiconductor chip shown in Fig. 1, in which a through silicon via penetrating through a silicon substrate 101, a connecting plug 104 composed of a metal such as copper, tungsten, etc., which is provided so as to protrude from the inside of the via to a rear surface of the silicon substrate 101, and a redistribution layer 107 are provided, is watched. This is because in addition to such an advantage of the conventional three-dimensional multi-chip semiconductor devices that in view of stacking of semiconductor chips, an occupied area by the semiconductor chips relative to a semiconductor substrate can be reduced, the electrical conduction goes through the through silicon via, so electrical deterioration is few, and the operating speed of a semiconductor package can be enhanced; and furthermore, a space between the semiconductor chips to be stacked can be made narrow, so it is possible to contrive to achieve more downsizing.

As a method for manufacturing a semiconductor chip for three-dimensional multi-chip semiconductor device having a through silicon via as described above, there are proposed some methods (see, for example, Patent Documents 1 to 3) . A method for providing a silicon substrate with a through silicon via penetrating through the silicon substrate, a connecting plug provided within the via, and a redistribution layer is in general called a through silicon via process.
The through silicon via process always includes a silicon substrate rear surface etching step of performing etching from a rear surface of a silicon substrate on which a wiring or the like is not provided, thereby thinning the silicon substrate. In the case where the etching step is performed by means of wet etching with an etching liquid, when the silicon substrate is thinned step by step, the connecting plug coated on the silicon substrate, which is composed of a metal such as copper, tungsten, etc., or polysilicon or the like, appears, and by further thinning the silicon substrate, a connecting plug having such a structure that it protrudes from the inside of the via to the rear surface of the silicon substrate is obtained. At that time, the silicon substrate and the connecting plug come into contact with the etching liquid at the same time. In this regard, if the used etching liquid is not appropriate, there are caused a variety of problems.

For example, for the rear surface etching which is carried out in the thinning step of a silicon substrate, an alkali based etching liquid, an acid based etching liquid, or the like is used. But, the alkali based etching liquid is inferior in etching performances, and a sufficient etching rate is not obtained, and therefore, there is involved such a problem that the production efficiency is lowered. In particular, the thinning step of a silicon substrate requires delicate processing, and it is general to achieve the thinning step by single wafer processing, and therefore, influences against a lowering of the production efficiency in the case of a slow etching rate of the etching liquid are conspicuous.
For that reason, in the thinning step of a silicon substrate, in general, an acid based etching liquid containing a mixed acid composed of a combination of hydrofluoric acid, nitric acid, acetic acid, and the like is preferably used (see, for example, Patent Documents 4 and 5) . But, in the case where a mixed acid is used as the etching liquid, even copper or tungsten which is not originally intended to be etched is dissolved and etched, resulting in a problem of lowering performances of a semiconductor package.

Nevertheless there are involved a variety of problems as described above, though Patent Document 1 describes that in the etching step of thinning a silicon substrate, a method such as dry etching, wet etching, CMP (chemical mechanical polishing), etc. is adopted, detailed investigations are not made at all. Also, the method such as dry etching and CMP involves such a problem that the connecting plug is polished, too. Patent Documents 2 and 3 merely describe that in the etching step, a usual etching method or a usual polishing method such as wafer rear surface polishing can be adopted, or the etching step is performed by at least one method of either of a grinding method or an etching method, but detailed investigations are not made at all.

In the light of the above, in the etching step of the silicon substrate rear surface in the through silicon via process, an etching liquid capable of etching only the silicon substrate without etching the connecting plug composed of a metal such as copper, tungsten, etc., or polysilicon or the like, and having an excellent etching rate is desired. However, it is the current situation that there is no effective etching liquid capable of solving these problems.

Patent Document 1: Japanese Patent No. 4011695
Patent Document 2: JP-A-2002-305283
Patent Document 3: JP-A-2009-4722
Patent Document 4: JP-A-2000-124177
Patent Document 5: JP-A-2005-217193

### BRIEF DESCRIPTION OF THE DRAWINGS

Fig. 1 is a schematic view showing a section of a semiconductor chip manufactured by a manufacturing method of the present invention.
Fig. 2 is a schematic view showing a section of a semiconductor chip of every step in Manufacturing Method A of the present invention.
Fig. 3 is a schematic view showing a section of a semiconductor chip of every step in Manufacturing Method B of the present invention.
Fig. 4 is a schematic view showing a section of a semiconductor chip sample obtained in Manufacturing Examples 1 and 2.
Fig. 5 is a schematic view showing a section of a semiconductor chip sample obtained in Manufacturing Examples 1 and 2 after etching.
Fig. 6 is a schematic view showing a section of a semiconductor chip sample obtained in Manufacturing Examples 3 and 4.
Fig. 7 is a schematic view showing a section of a semiconductor chip sample obtained in Manufacturing Examples 3 and 4 after etching.

### EXPLANATIONS OF LETTERS OR NUMERALS

101: Silicon substrate
102: Integrated circuit
103: Pad
104: Connecting plug
105: Insulating layer
106: Insulating layer
107: Redistribution layer
108: Protective film
109: Bump
110: Adhesive layer
111: Glass substrate
112: Insulating layer (formed by an integrated device and a pad forming step)
113: Seed layer
301: Silicon substrate
302: Integrated circuit
303: Pad
304: Connecting plug
305: Barrier layer
306: Insulating layer
307: Redistribution layer
308: Protective film
309: Bump
310: Adhesive layer
311: Glass substrate
312: Insulating layer (formed by an integrated device and a pad forming step)

### DISCLOSURE OF THE INVENTION

### PROBLEMS TO BE SOLVED BY THE INVENTION

Under such circumstances, the present invention has been made, and its object is to provide an etching liquid which is used for etching a silicon substrate rear surface in a through silicon via process, etches only a silicon substrate without etching a connecting plug composed of a metal such as copper, tungsten, etc. , or polysilicon or the like, and has an excellent etching rate; and a method for manufacturing a semiconductor chip having a through silicon via using the same.

### MEANS FOR SOLVING THE PROBLEMS

In order to achieve the foregoing object, the present inventors made extensive and intensive investigations. As a result, it has been found that the foregoing problems can be solved by using an alkali based etching liquid containing potassium hydroxide, hydroxylamine, and water. That is, the gist of the present invention is as follows.

[1] An etching liquid for etching a silicon substrate rear surface in a through silicon via process containing potassium hydroxide, hydroxylamine, and water.
[2] The etching liquid as set forth above in [1], wherein a content of potassium hydroxide is from 15 to 50 % by mass, and a content of hydroxylamine is from 10 to 40 % by mass.
[3] The etching liquid as set forth above in [1] or [2], wherein the silicon substrate has a redistribution layer and a connecting plug, and the connecting plug is protruded to the silicon substrate rear surface on which the redistribution layer is not provided.
[4] The etching liquid as set forth above in [3], wherein the connecting plug is composed of at least one member selected from polysilicon, copper, and tungsten.
[5] A method for manufacturing a semiconductor chip having a through silicon via, which includes a silicon substrate rear surface etching step using the etching liquid as set forth above in any one of [1] to [4].
[6] The method for manufacturing a semiconductor chip as set forth above in [5] , wherein the silicon substrate rear surface etching step includes (1) a silicon substrate thinning step of thinning a silicon substrate in such a state that an insulating layer covering a connecting plug is coated on the silicon substrate and (2) a silicon substrate thinning step of protruding the insulating layer in this order; and in at least the silicon substrate thinning step (2), the etching liquid as set forth above in any one of [1] to [4] is used.
[7] The method for manufacturing a semiconductor chip as set forth above in [6], wherein a total sum of a distance between the silicon substrate rear surface at the time of termination of the silicon substrate thinning step (1) and a surface of the insulating layer on the silicon substrate rear surface side and a distance between a surface of the insulating layer on the silicon substrate rear surface side at the time of termination of the silicon substrate thinning step (1) and the silicon substrate rear surface at the time of termination of the silicon substrate thinning step (2) falls within the range of from 20 to 30 µm.
[8] The method for manufacturing a semiconductor chip as set forth above in [6] or [7], wherein the connecting plug is composed of at least one member selected from polysilicon, copper, and tungsten.
[9] The method for manufacturing a semiconductor chip as set forth above in any one of [5] to [8], wherein the semiconductor chip is one used for three-dimensional multi-chip semiconductor devices.

### EFFECTS OF THE INVENTION

According to the present invention, there can be provided an etching liquid which is used for etching a silicon substrate rear surface in a through silicon via process, etches only a silicon substrate without etching a connecting plug composed of a metal such as copper, tungsten, etc., or polysilicon or the like, and has an excellent etching rate; and a method for manufacturing a semiconductor chip for three-dimensional multi-chip semiconductor device having a through silicon via using the same.

### BEST MODES FOR CARRYING OUT THE INVENTION

### [Etching liquid]

The etching liquid of the present invention is a liquid which is used for etching a silicon substrate rear surface in a through silicon via process and which contains potassium hydroxide, hydroxylamine, and water.

A content of potassium hydroxide in the etching liquid of the present invention is preferably from 10 to 50 % by mass, more preferably from 15 to 50 % by mass, and still more preferably from 20 to 40 % by mass. So far as the content of potassium hydroxide falls within the foregoing range, the appearance and functions of the semiconductor chip are not adversely affected, and an enhancing effect of an etching rate due to the addition of hydroxylamine can be sufficiently obtained.

Though a content of hydroxylamine in the etching liquid of the present invention is properly determined depending upon the solubility of hydroxylamine in water, the content of potassium hydroxide in the etching liquid, the content of other additives, and the like, it is preferably from 5 to 50 % by mass, more preferably from 8 to 40 % by mass, and still more preferably from 10 to 40 % by mass. So far as the content of hydroxylamine falls within the foregoing range, a sufficient etching rate is obtained, neither crystal deposition nor solidification is caused in the etching liquid, and handling is easy.

### <<Other components>>

The etching liquid of the present invention can be blended with additives which have hitherto been used.

A pH of the etching liquid of the present invention is preferably alkaline as more than 7, and more preferably 11 or more.

The etching liquid of the present invention is used for etching a silicon substrate rear surface in a through silicon via process. The through silicon via process is not particularly limited so far as it is a method for providing a silicon substrate with a through silicon via penetrating through the silicon substrate, a connecting plug provided within the via, and a redistribution layer. For example, in the through silicon via process or manufacturing method of a semiconductor device disclosed in Patent Documents 1 to 3, in the case where thinning (etching) of a silicon substrate is performed by means of wet etching, the etching liquid of the present invention can be suitably used as an etching liquid in the etching.

Also, the etching liquid of the present invention can be suitably used for not only the silicon substrate rear surface etching in the through silicon via process but a process which is concerned with thinning (etching) of a silicon substrate and in which the silicon substrate and a connecting plug (wiring material) composed of a metal such as copper, tungsten, etc., or polysilicon or the like become in a state of being exposed to the etching liquid at the same time. More specifically, in the through silicon via process, in the case where the silicon substrate becomes in such a state that the connecting plug protrudes to the rear surface of the silicon substrate on the opposite side to the side of the silicon substrate on which a redistribution layer is provided, the effects of the etching liquid of the present invention can be effectively utilized, and therefore, such is preferable.

### [Manufacturing method of semiconductor chip]

A method for manufacturing a semiconductor chip for three-dimensional multi-chip semiconductor device having a through silicon via according to the present invention is a method for manufacturing a semiconductor chip comprising a silicon substrate having thereon a through silicon via penetrating through the silicon substrate, a connecting plug provided within the via, and a redistribution layer, and may be said to be one of through silicon via processes. Then, the manufacturing method of the present invention comprises using the etching liquid of the present invention in one step in the manufacturing method, namely a silicon substrate rear surface etching step that is one step in the through silicon via process.

### <<Through silicon via process>>

In the manufacturing method of the present invention, there are no limitations regarding an embodiment of other steps so far as the etching liquid of the present invention is used in an etching step thereof, and the silicon substrate is provided with a through silicon via penetrating through the silicon substrate, a connecting plug provided within the via, and a redistribution layer. Examples of typical and preferred embodiments of the manufacturing method of the present invention are described.

### (Manufacturing Method A)

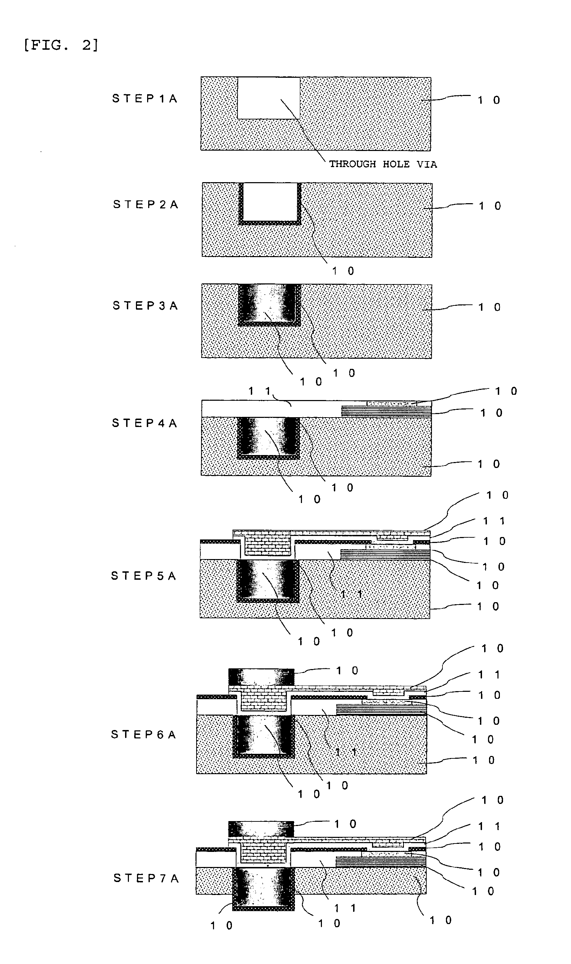

As for an example of preferred embodiments of the manufacturing method of the present invention, there is exemplified Manufacturing Method A including the following Steps 1A to 7A in this order. First of all, Manufacturing Method A is described by reference to Fig. 2 showing a schematic view of a section of a semiconductor chip of every step of Steps 1A to 7A.
Step 1A: Through hole via forming step of forming a through hole via on a silicon substrate
Step 2A: Insulating layer forming step of forming an insulating layer on a side wall of the through hole via
Step 3A: Connecting plug forming step of forming a connecting plug within the through hole via
Step 4A: Semiconductor device forming step of forming a semiconductor device-containing integrated circuit and a pad
Step 5A: Redistributing step of redistributing the integrated circuit and the connecting plug
Step 6A: Forming step of a bump electrode
Step 7A: Etching step of a silicon substrate rear surface

### <Step 1A>

Step 1A is a through hole via forming step of forming a through hole via on a silicon substrate. The through hole via can be formed by a method in which a mask pattern having an opening in a portion where the through hole via is formed is formed of a photoresist, and etching is performed to a depth at which a silicon substrate is not penetrated, or by means of laser drilling or the like.

### <Step 2A>

Step 2A is a step of forming an insulating layer 105 on a side wall within the through hole via formed in Step 1A. The insulating layer 105 is a layer which is provided for insulating a silicon substrate 101 and a connecting plug 104 provided within the through hole via from each other. The insulating layer 105 is composed of an oxide film of silicon oxide, etc. formed by a method such as oxidation by heating, vapor deposition, etc. on the silicon surface in an oxygen atmosphere, or a nitride film or the like.

### <Step 3A>

Step 3A is a step of forming the connecting plug 104 in a cavity portion within the through hole via having the insulating layer 105 formed on the side wall thereof. As a material for forming the connecting plug 104, there are preferably exemplified a variety of materials such as metals, e.g., copper, tungsten, platinum, etc., polysilicon, and the like. The formation of the connecting plug 104 can be performed by means of vapor deposition, sputtering, or the like.

### <Step 4A>

Step 4A is a step of forming a semiconductor device-containing integrated circuit 102 and a pad 103 on the silicon substrate 101 having the connecting plug 104 and the insulating layer 105 provided within the through hole via. In the manufacturing method of the present invention, the formation of the integrated circuit 102 and the pad 103 may be performed by a known method and is not particularly limited. Also, in the formation of the integrated circuit 102 and the pad 103, in general, an insulating layer 112 composed of silicon oxide, silicon nitride, or the like is formed.

### <Step 5A>

Step 5A is a redistributing step of redistributing the integrated circuit 102 (pad 103) formed in Step 4A and the connecting plug 104. A redistribution layer may be formed by a known method. For example, the redistribution layer can be formed by (i) a method in which an insulating layer 106 opened in upper parts of the through hole via and the pad 103 is provided; a wiring composed of a metal of various sort such as copper, etc. is successively provided on a seed layer 113 formed by sputtering copper or the like, a photoresist film having an opening and including the pad 103 and the connecting plug 104, and the opening by means of electroplating; the photoresist film is then removed; and a portion of the seed layer 113 which is not covered by the wiring is etched; (ii) a method in which a metal film is formed on a silicon substrate by means of sputtering or vapor deposition of a metal of various sort such as copper, tungsten, etc., or other means, and the metal film is etched while masking with a photosensitive film pattern; or the like. The redistribution layer may be either single-layered or multi-layered and may be properly chosen depending upon an application of the semiconductor chip.

Also, the insulating layer 106 can be formed by means of vapor deposition of silicon oxide or a nitride or the like, or coating of an insulating organic material such as an epoxy resin, a polyimide resin, etc. Incidentally, in the case where the adhesion between the metal of various sort for forming the redistribution layer and the insulating layer 106 is insufficient, or in the case where the metal of various sort for forming the redistribution layer is diffused into the insulating layer 106, after forming the insulating layer 106, a barrier layer composed of titanium, titanium nitride, or the like may be provided so as to cover the insulating layer 106 and the pad 103.

After providing the redistribution layer 107, a protective film 108 of the redistribution layer 107 can also be provided, if desired. The protective film 108 can be provided by forming an oxide film such as silicon oxide, etc. by a method such as oxidation by heating, vapor deposition, etc. on the silicon surface in an oxidation atmosphere, or a nitride film or the like, or formed by a method such as vapor deposition, coating, etc. by using an insulating organic material such as an epoxy resin, a polyimide resin, etc., or the like.

### <Step 6A>

A bump can be, for example, formed by coating an insulating organic material such as an epoxy resin, a polyimide resin, etc. so as to cover the redistribution layer 107 formed in Step 5 to form an insulating film, providing an opening in a portion of the insulating film which is intended to be provided with a bump by means of etching or the like, and then performing electroplating by using gold, palladium, nickel, copper, or the like in addition to tin, lead or an alloy thereof (tin-lead alloy).

### <Step 7A>

Step 7A is a silicon substrate rear surface etching step of thinning a rear surface of the silicon substrate on which the redistribution layer 107 or the like is not provided, and the etching liquid of the present invention is used for the etching. In thinning (etching) the entirety of the silicon substrate rear surface which is performed in Step 7A, though the etching liquid of the present invention can be used, from the viewpoint of production efficiency, it is preferable that Step 7A includes a silicon substrate thinning step (1) of thinning the silicon substrate 101 in such a state that the insulating layer 105 covering the connecting plug 104 is coated on the silicon substrate 101 and a silicon substrate thinning step (2) of protruding the insulating layer 105 in this order; and that the foregoing etching liquid of the present invention is used in the silicon substrate thinning step (2).

In the silicon substrate thinning step (1), though as described above, thinning of the silicon substrate can be performed by means of wet etching with the etching liquid of the present invention, the thinning can be performed by a polishing method such as chemical polishing, mechanical polishing, chemical mechanical polishing, etc. or other method which is usually adopted for thinning of a silicon substrate, such as wet etching with an acid based etching liquid or the like, dry etching, e.g., plasma etching or gas etching, and a combination thereof.
Of these, from the standpoint of fast etching, in general, thinning by chemical polishing is frequently adopted.

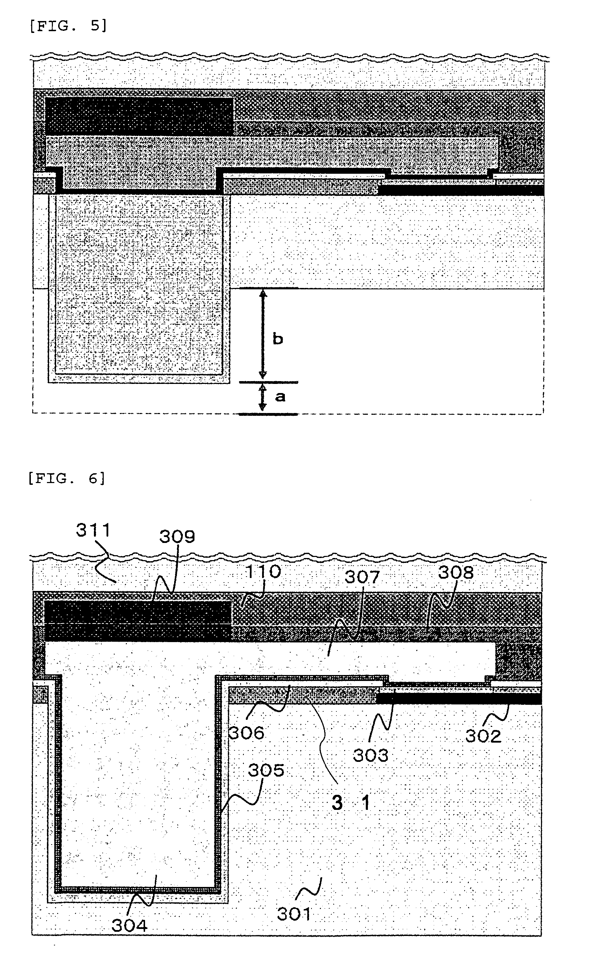

Also, taking the working stability and production efficiency into consideration, it is preferable to terminate the silicon substrate thinning step (1) within the range where a distance between the silicon substrate rear surface and the surface of the insulating layer 105 on the silicon substrate rear surface side (a in Fig. 5) is from 5 to 15 µm, thereby transferring the step into the subsequent silicon substrate thinning step (2).

The silicon substrate thinning step (2) is a step of protruding the insulating layer 105 covering the connecting plug 104 by means of etching, and the foregoing etching liquid of the present invention is used for the etching.
In the case of stacking semiconductor chips obtained by the manufacturing method of the present invention to form a three-dimensional multi-chip semiconductor device, from the viewpoints of working stability and reliability, it is preferable that a height of the connecting plug to be protruded from the silicon substrate rear surface after etching falls within the range of from 10 to 20 µm. In the silicon substrate thinning step (2), from the viewpoint of production efficiency, it is preferable that a thickness of the silicon substrate to be etched with the etching liquid of the present invention, namely a sum (a + b) of a distance between the silicon substrate rear surface at the time of termination of the silicon substrate thinning step (1) and the surface of the insulating layer 105 on the silicon substrate rear surface side (a in Fig. 5), and a distance between the surface of the insulating layer on the silicon substrate rear surface side at the time of termination of the silicon substrate thinning step (1) and the silicon substrate rear surface at the time of termination of the silicon substrate thinning step (2) (b in Fig. 5) falls within the range of from 20 to 30 µm.

A method of bringing the etching liquid into contact with an etching object is not particularly limited, and for example, a method of bringing the etching liquid into contact with the object by a mode of dropwise addition, spraying, or the like, a method of dipping the object in the etching liquid, or other method can be adopted. In the present invention, single wafer spin processing is preferably adopted.

A use temperature of the etching liquid is preferably a temperature of 50°C or higher and lower than a boiling point thereof, more preferably from 50 to 90°C, still more preferably from 60 to 90°C, and especially preferably from 70 to 90°C. So far as the temperature of the etching liquid falls within the foregoing range, the etching rate does not become excessively low; and therefore, the production efficiency is not conspicuously lowered, a change in liquid composition is suppressed, and the etching condition can be kept constant. When the temperature of the etching liquid is increased, the etching rate elevates. However, when the matter that the change in the etching liquid composition is controlled to be small or the like is taken into consideration, an optimum processing temperature may be properly determined.

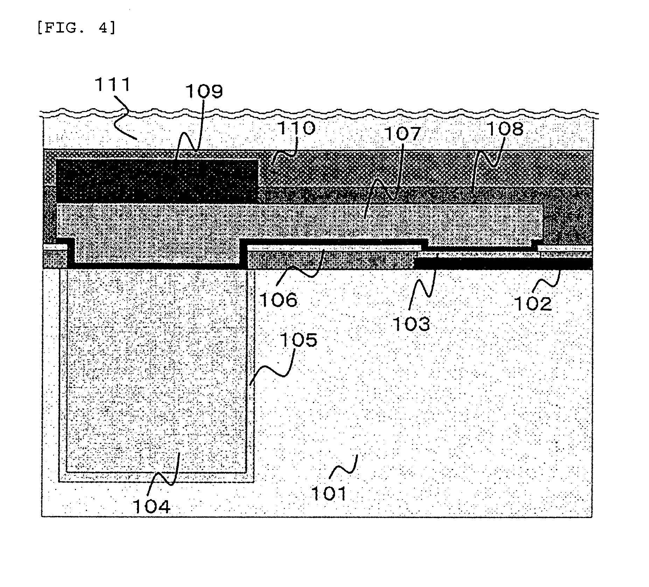

In performing the present step, as shown in Fig. 4, a glass substrate 111 can be preferably used as a support jig for thinning via an adhesive layer 110 on the surface of the semiconductor chip on which the redistribution layer 107 or the like is provided. By using the support jig, stable etching can be performed.

### (Manufacturing Method B)

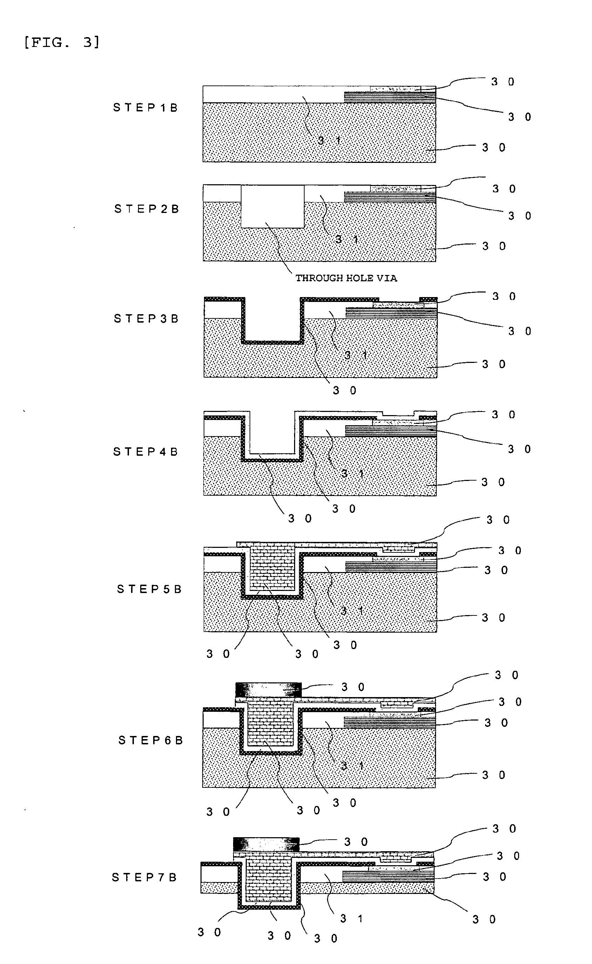

Also, as for an example of preferred embodiments of the manufacturing method of the present invention, there is exemplified Manufacturing Method B including the following Steps 1B to 7B in this order. Manufacturing Method B is described by reference to Fig. 3 showing a schematic view of a section of a semiconductor chip of every step of Steps 1B to 7B.
Step 1B: Semiconductor device forming step of forming a semiconductor device-containing integrated circuit and a pad on a silicon substrate
Step 2B: Through hole via forming step of forming a through hole via on the silicon substrate
Step 3B: Insulating layer forming step of forming an insulating layer on an inner wall of the through hole via and the silicon substrate surface such that an upper part of a pad on the silicon substrate surface is opened
Step 4B: Barrier layer forming step of forming a barrier layer on the entire surface of the silicon substrate including the through hole via inner wall
Step 5B: Connecting plug forming/redistributing step of not only forming a connecting plug within the through hole via but redistributing the integrated circuit and the connecting plug
Step 6B: Forming step of a bump electrode
Step 7B: Etching step of a silicon substrate rear surface

Manufacturing Method B is a method in which the semiconductor device forming step of Step 4A of Manufacturing Method A is first performed, and Manufacturing Method A is called a via first process, whereas Manufacturing Method B is called a via last process.

### <Steps 1B and 2B>

Steps 1B and 2B are the same as Step 4A and Step 1A, respectively.

### <Step 3B>

In Step 3B, an integrated circuit 302 and a pad 303 are formed before an insulating layer 306 is provided. Accordingly, in Step 3B, the insulating layer 306 can be formed at the same time on an inner wall of a through hole via and in a portion excluding an opening to be provided in an upper part of the pad 303 on the surface of a silicon substrate 301. At this point, according to the via last process of Manufacturing Method B, it is possible to contrive to achieve shortening of the manufacturing steps and a reduction of the manufacturing costs.

### <Step 4B>

Step 4B is a step of providing a barrier layer by forming a barrier layer 305 on the entire surface of the silicon substrate 301 including the through hole via inner wall for the purpose of not only sufficiently ensuring the adhesion between a redistribution layer 307 and the insulating layer 306 but suppressing the diffusion of the redistribution layer 307 into the insulating layer 306.

### <Step 5B>

Step 5B is a step of forming a connecting plug 304 in a cavity portion within the through hole via in which the insulating layer 306 and the barrier layer 305 are formed in this order in an inner wall thereof and simultaneously redistributing the integrated circuit 302 (pad 303) and the connecting plug 304. For example, after the insulating layer 306 and the barrier layer 305 are provided in this order according to the foregoing methods of Steps 3B and 4B, the connecting plug 304 and the redistribution layer 307 can be formed by (i) a method in which a metal material composed of copper or the like is accumulated on a seed layer formed by sputtering copper or the like, a photoresist film having an opening and including the pad 303 and the connecting plug 304, and the opening by means of electroplating, thereby providing an electrically conductive layer; the photoresist film is then removed; and portions of the seed layer and the barrier layer 305 which are not covered by the electrically conductive layer are etched; (ii) a method in which a metal material such as tungsten, etc. is accumulated on a silicon substrate by means of sputtering, vapor deposition, or the like, thereby forming a metal film, and the metal film is etched while masking with a photosensitive film pattern; or the like.

### <Steps 6B and 7B>

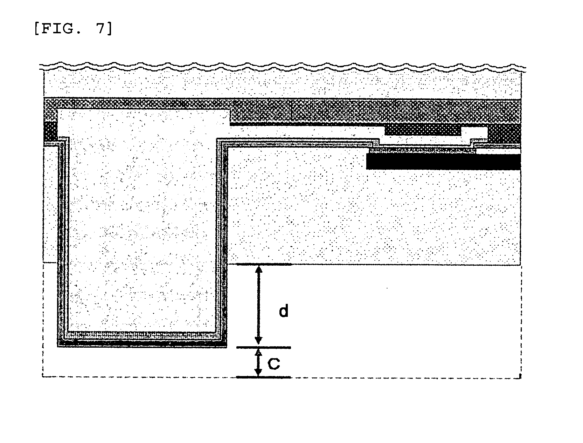

Steps 6B and 7B are the same as Steps 6A and 7A, respectively. Also, a distance between the silicon substrate rear surface at the time of termination of the silicon substrate thinning step (1) and the surface of the insulating layer 306 on the silicon substrate rear surface side is corresponding to c in Fig. 7; and a distance between the surface of the insulating layer 306 on the silicon substrate rear surface side at the time of termination of the silicon substrate thinning step (1) and the silicon substrate rear surface at the time of termination of the silicon substrate thinning step (2) is corresponding to d in Fig. 7.

### (Other manufacturing method)

The manufacturing method of the present invention may also be a method of using the etching liquid of the present invention in the thinning (etching) step of a silicon substrate in the through silicon via process disclosed in, for example, Patent Documents 1 to 3.

In the semiconductor chips obtained by the present invention, the electrical conduction goes through the through silicon via, so electrical deterioration is few, and the operating speed of a semiconductor package can be enhanced. Also, in the case of stacking the chips, a space between the semiconductor chips can be made narrow, so the semiconductor chips are suitably useful for three-dimensional multi-chip semiconductor devices.

### EXAMPLES

Next, the present invention is described in more detail by reference to the following Examples, but it should be construed that the present invention is not limited to these Examples at all.

### Evaluation item 1: Evaluation of productivity (etching processing time)

A semiconductor chip sample for three-dimensional multi-chip semiconductor device obtained in each of the following Manufacturing Examples was etched with an etching liquid at a processing temperature shown in Table 1 or 2 by using a single wafer spin apparatus and subjected to etching processing so as to have an etching amount shown in Table 1 or 2, and a time necessary for the processing was evaluated according to the following criteria. Incidentally, the etching amount b in Table 1 and the etching amount d in Table 2 are a height of each of the connecting plugs 104 and 304 protruding from the silicon substrate rear surfaces 101 and 301, respectively as shown in Figs. 4 and 5.
A: The time necessary for the processing was within 4 minutes.
B: The time necessary for the processing was within 5 minutes.
C: The time necessary for the processing was within 7 minutes.
D: The processing did not terminate within 7 minutes.

### Evaluation item 2: Evaluation of shape after the etching processing

A sample obtained in each of the following Manufacturing Examples was etched with an etching liquid at a processing temperature shown in Table 1 or 2 by means of dipping and subjected to etching processing so as to have an etching amount shown in Table 1 or 2, and thereafter, the state of the connecting plug was evaluated according to the following criteria.
A: The connecting plug was not dissolved in the etching liquid, whereby a prescribed height of the connecting plug was obtained.
B: The connecting plug was dissolved in the etching liquid, whereby a prescribed height of the connecting plug was not obtained, or the silicon substrate could not be etched.

### Preparation Example (Preparation of etching liquid)

An etching liquid used in each of the following Examples and Comparative Examples was prepared according to a blending composition (% by mass) shown in Table 1.

### Manufacturing Example 1 (Manufacture 1 of semiconductor chip by via first (Manufacturing Method A))

On a silicon substrate 101 (thickness: 775 µm) , a mask pattern having an opening was formed of a photoresist; etching was performed to a depth at which the silicon substrate was not penetrated, thereby forming a through hole via (diameter: 30 µm, depth: 40 µm) in the opening; and silicon was subjected to oxidation by heating on an inner wall of the through hole via, thereby forming an insulating layer 105 having a thickness of 0.4 µm. Subsequently, polysilicon was embedded within the through hole via having the insulating layer 105 provided on the inner wall thereof by means of sputtering, thereby forming a connecting plug 104; a semiconductor device-containing integrated circuit 102 and a pad 103 on an upper surface of the integrated circuit 102 were provided in this order; and an insulating layer 106 having an opening on the through hole via and an upper part of the pad 103 was provided by means of vapor deposition with silicon oxide. After providing the insulating layer 106, a wiring composed of copper was successively provided on a barrier layer formed by sputtering titanium, a seed layer formed by sputtering copper, a photoresist film having an opening and including the pad 103 and the connecting plug 104, and the opening by means of electroplating; the photoresist film was then removed; and portions of the barrier layer and the seed layer which were not covered by the wiring were etched, thereby obtaining a redistribution layer 107. Furthermore, a bump 109 composed of copper was provided on the redistribution layer 107 in an upper part of the connecting plug 104 by means of plating, and a protective film 108 of the redistribution layer was provided using a polyimide resin, thereby obtaining a semiconductor chip for three-dimensional multi-chip semiconductor device having a through silicon via. As shown in Fig. 4, the obtained semiconductor chip was fixed to a glass substrate 111 that is a support jig via an adhesive layer 110, and the rear surface of the silicon substrate 101 was then polished until a shown in Fig. 5 (distance between the silicon substrate rear surface and the surface of the insulating layer 105 covering the connecting plug 104 on the silicon substrate rear surface side) reached 10 µm, thereby obtaining a semiconductor chip sample 1 for three-dimensional multi-chip semiconductor device.

### Manufacturing Example 2 (Manufacture 2 of semiconductor chip by via first (Manufacturing Method A))

A semiconductor chip sample 2 for three-dimensional multi-chip semiconductor device was obtained in the same manner as that in Manufacturing Example 1, except that in Manufacturing Example 1, the material for forming the connecting plug 104 was changed from polysilicon to tungsten.

### Manufacturing Example 3 (Manufacture 1 of semiconductor chip by via last (Manufacturing Method B))

On a semiconductor device-containing integrated circuit 302 and a silicon substrate 301 (thickness: 775 µm) having a pad 303 provided on an upper surface of the integrated circuit 302, a mask pattern having an opening was formed of a photoresist; etching was performed to a depth at which the silicon substrate was not penetrated, thereby forming a through hole via (diameter: 30 µm, depth: 40 µm) in the opening; and silicon oxide was subjected to vapor deposition on an inner wall of the through hole via and the silicon substrate 301 so as to have an opening on the pad 303, thereby forming an insulating layer 306 having a thickness of 0.4 µm. Subsequently, a barrier layer 305 (thickness: 0.1 µm) was formed by sputtering titanium so as to cover the pad 303 within the through hole via having the insulating layer 306 provided on the inner wall thereof and on the silicon substrate 301, and copper was then sputtered on the barrier layer 305 to form a seed layer. Furthermore, an electrically conductive layer composed of copper was successively provided on the insulating layer 306, the inside of the through hole via having the barrier layer 305 and the seed layer formed therein, the photoresist film having an opening and including the pad 303, and the opening by means of electroplating; the photoresist film was then removed; and portions of the barrier layer 305 and the seed layer which were not covered by the electrically conductive layer composed of copper by means of electroplating were etched, thereby simultaneously obtaining a connecting plug 304 and a redistribution layer 307. Furthermore, a bump 309 composed of copper was provided on the rewiring 307 in an upper part of the connecting plug 304 by means of plating, and a protective film 308 of the redistribution layer was provided using a polyimide resin, thereby obtaining a semiconductor chip having a through silicon via. As shown in Fig. 6, the obtained semiconductor chip was fixed to a glass substrate 311 that is a support jig via an adhesive layer 310, and the rear surface of the silicon substrate 301 was then polished until c shown in Fig. 7 (distance between the silicon substrate rear surface and the surface of the insulating layer 305 covering the connecting plug 304 on the silicon substrate rear surface side) reached 10 µm, thereby obtaining a semiconductor chip sample 3 for three-dimensional multi-chip semiconductor device.

### Manufacturing Example 4 (Manufacture 4 of semiconductor chip by via last (Manufacturing Method B))

A semiconductor chip sample 4 for three-dimensional multi-chip semiconductor device was obtained in the same manner as that in Manufacturing Example 3, except that in Manufacturing Example 3, the material for forming the connecting plug 304 was changed from copper to tungsten.

### Examples 1 to 57 and Comparative Examples 1 to 3

The semiconductor chip sample 1 for three-dimensional multi-chip semiconductor device obtained in Manufacturing Example 1 was etched with an etching liquid at a processing temperature shown in Table 1 by using a single wafer spin apparatus and subjected to etching processing so as to have an etching amount shown in Table 1 (a and b shown in Fig. 5).
The processing time and shape were evaluated on the basis of the foregoing evaluation criteria. The evaluation results are shown in Table 1. Also, the semiconductor chip sample 2 for three-dimensional multi-chip semiconductor device obtained in Manufacturing Example 2 was evaluated in the same manners as those in the semiconductor chip sample 1 for three-dimensional multi-chip semiconductor device. As a result, the same results as those in the semiconductor chip sample 1 for three-dimensional multi-chip semiconductor device were revealed.

### Examples 58 to 114 and Comparative Examples 4 to 6

The semiconductor chip sample 3 for three-dimensional multi-chip semiconductor device obtained in Manufacturing Example 3 was etched with an etching liquid at a processing temperature shown in Table 2 by using a single wafer spin apparatus and subjected to etching processing so as to have an etching amount shown in Table 2 (c and d shown in Fig. 7) . The processing time and shape were evaluated on the basis of the foregoing evaluation criteria. The evaluation results are shown in Table 2. Also, the semiconductor chip sample 4 for three-dimensional multi-chip semiconductor device obtained in Manufacturing Example 4 was evaluated in the same manners as those in the semiconductor chip sample 3 for three-dimensional multi-chip semiconductor device. As a result, the same results as those in the semiconductor chip sample 3 for three-dimensional multi-chip semiconductor device were revealed.

**Table 1**

| Example No. | Composition of etching liquid | | | | Etching amount | | | Processing temperature (°C) | Evaluation results | | |
|---|---|---|---|---|---|---|---|---|---|---|---|
| | Hydroxylamine (% by mass) | Inorganic alkaline compound | | Water concentration (% by mass) | | | | | Evaluation of productivity | | Evaluation of shape |
| | | Kind | Concentration (% by mass) | | a (µm) | b (µm) | a + b | | (min) | Evaluation | |
| Example 1 | 10 | KOH | 10 | 80 | 10 | 10 | 20 | 90 | 4 | A | A |
| Example 2 | 10 | KOH | 10 | 80 | 10 | 15 | 25 | 90 | 5 | B | A |
| Example 3 | 10 | KOH | 15 | 75 | 10 | 10 | 20 | 80 | 5 | B | A |
| Example 4 | 10 | KOH | 15 | 75 | 10 | 10 | 20 | 90 | 4 | A | A |
| Example 5 | 10 | KOH | 15 | 75 | 10 | 15 | 25 | 90 | 5 | B | A |
| Example 6 | 10 | KOH | 15 | 75 | 10 | 20 | 30 | 90 | 6 | C | A |
| Example 7 | 10 | KOH | 20 | 70 | 10 | 10 | 20 | 80 | 4 | A | A |
| Example 8 | 10 | KOH | 20 | 70 | 10 | 15 | 25 | 80 | 6 | C | A |
| Example 9 | 10 | KOH | 20 | 70 | 10 | 20 | 30 | 90 | 5 | B | A |
| Example 10 | 10 | KOH | 25 | 65 | 10 | 10 | 20 | 80 | 4 | A | A |
| Example 11 | 10 | KOH | 25 | 65 | 10 | 15 | 25 | 80 | 5 | B | A |
| Example 12 | 10 | KOH | 25 | 65 | 10 | 20 | 30 | 90 | 4 | A | A |
| Example 13 | 10 | KOH | 30 | 60 | 10 | 15 | 25 | 80 | 5 | B | A |
| Example 14 | 15 | KOH | 10 | 75 | 10 | 10 | 20 | 80 | 6 | C | A |
| Example 15 | 15 | KOH | 10 | 75 | 10 | 20 | 30 | 90 | 6 | C | A |
| Example 16 | 15 | KOH | 15 | 70 | 10 | 10 | 20 | 80 | 5 | B | A |
| Example 17 | 15 | KOH | 15 | 70 | 10 | 15 | 25 | 80 | 6 | C | A |
| Example 18 | 15 | KOH | 15 | 70 | 10 | 20 | 30 | 90 | 5 | B | A |
| Example 19 | 15 | KOH | 20 | 65 | 10 | 10 | 20 | 70 | 6 | C | A |
| Example 20 | 15 | KOH | 20 | 65 | 10 | 10 | 20 | 80 | 4 | A | A |
| Example 21 | 15 | KOH | 20 | 65 | 10 | 15 | 25 | 80 | 5 | B | A |
| Example 22 | 15 | KOH | 20 | 65 | 10 | 20 | 30 | 80 | 6 | C | A |
| Example 23 | 15 | KOH | 25 | 60 | 10 | 10 | 20 | 70 | 5 | B | A |
| Example 24 | 15 | KOH | 25 | 60 | 10 | 15 | 25 | 80 | 4 | A | A |
| Example 25 | 15 | KOH | 25 | 60 | 10 | 20 | 30 | 80 | 5 | B | A |
| Example 26 | 15 | KOH | 30 | 55 | 10 | 10 | 20 | 70 | 4 | A | A |
| Example 27 | 15 | KOH | 30 | 55 | 10 | 20 | 30 | 80 | 4 | A | A |
| Example 28 | 18 | KOH | 10 | 72 | 10 | 10 | 20 | 80 | 6 | C | A |
| Example 29 | 18 | KOH | 10 | 72 | 10 | 15 | 25 | 80 | 7 | C | A |
| Example 30 | 18 | KOH | 10 | 72 | 10 | 20 | 30 | 90 | 6 | C | A |
| Example 31 | 18 | KOH | 15 | 67 | 10 | 10 | 20 | 70 | 7 | C | A |
| Example 32 | 18 | KOH | 15 | 67 | 10 | 15 | 25 | 80 | 5 | B | A |
| Example 33 | 18 | KOH | 15 | 67 | 10 | 20 | 30 | 80 | 6 | C | A |
| Example 34 | 18 | KOH | 20 | 62 | 10 | 10 | 20 | 70 | 5 | B | A |
| Example 35 | 18 | KOH | 20 | 62 | 10 | 20 | 30 | 80 | 5 | B | A |
| Example 36 | 18 | KOH | 25 | 57 | 10 | 10 | 20 | 70 | 5 | B | A |
| Example 37 | 18 | KOH | 25 | 57 | 10 | 15 | 25 | 70 | 6 | c | A |
| Example 38 | 18 | KOH | 30 | 52 | 10 | 15 | 25 | 70 | 5 | B | A |
| Example 39 | 20 | KOH | 10 | 70 | 10 | 10 | 20 | 80 | 6 | C | A |
| Example 40 | 20 | KOH | 10 | 70 | 10 | 15 | 25 | 80 | 7 | C | A |
| Example 41 | 20 | KOH | 10 | 70 | 10 | 20 | 30 | 90 | 6 | C | A |
| Example 42 | 20 | KOH | 15 | 65 | 10 | 10 | 20 | 70 | 7 | C | A |
| Example 43 | 20 | KOH | 15 | 65 | 10 | 10 | 20 | 80 | 4 | A | A |
| Example 44 | 20 | KOH | 15 | 65 | 10 | 20 | 30 | 80 | 7 | C | A |
| Example 45 | 20 | KOH | 20 | 60 | 10 | 10 | 20 | 70 | 5 | B | A |
| Example 46 | 20 | KOH | 20 | 60 | 10 | 15 | 25 | 70 | 6 | C | A |
| Example 47 | 20 | KOH | 25 | 55 | 10 | 10 | 20 | 70 | 4 | A | A |
| Example 48 | 20 | KOH | 25 | 55 | 10 | 15 | 25 | 70 | 5 | B | A |
| Example 49 | 25 | KOH | 10 | 65 | 10 | 10 | 20 | 80 | 6 | C | A |
| Example 50 | 25 | KOH | 10 | 65 | 10 | 15 | 25 | 80 | 7 | C | A |
| Example 51 | 25 | KOH | 10 | 65 | 10 | 20 | 30 | 90 | 6 | C | A |
| Example 52 | 25 | KOH | 15 | 60 | 10 | 10 | 20 | 70 | 7 | C | A |
| Example 53 | 25 | KOH | 15 | 60 | 10 | 10 | 20 | 80 | 4 | A | A |
| Example 54 | 25 | KOH | 15 | 60 | 10 | 20 | 30 | 80 | 6 | C | A |
| Example 55 | 25 | KOH | 20 | 55 | 10 | 10 | 20 | 70 | 4 | A | A |
| Example 56 | 25 | KOH | 20 | 55 | 10 | 15 | 25 | 70 | 6 | C | A |
| Example 57 | 25 | KOH | 20 | 55 | 10 | 20 | 30 | 70 | 7 | C | A |
| Comparative Example 1 | Mixed acid (49 % hydrofluoric acid/70 % nitric acid = 1/8.5) | | | | 10 | 10 | 20 | 25 | 2 | A | B |
| Comparative Example 2 | 0 | KOH | 30 | 70 | 10 | 10 | 20 | 90 | 9 | D | A |
| Comparative Example 3 | 25 | - | 0 | 75 | 10 | 10 | 20 | 90 | >10 | D | B |

**Table 2**

| Example No. | Composition of etching liquid | | | | Etching amount | | | Processing temperature (°C) | Evaluation results | | |
|---|---|---|---|---|---|---|---|---|---|---|---|
| | Hydroxylamine (% by mass) | Inorganic alkaline compound | | Water concentration (% by mass) | | | | | Evaluation of productivity | | Evaluation of shape |
| | | Kind | Concentration (% by mass) | | c (µm) | d (µm) | c + d (µm) | | (min) | Evaluation | |
| Example 58 | 10 | KOH | 0 | 80 | 10 | 10 | 20 | 90 | 4 | A | A |
| Example 59 | 10 | KOH | 10 | 80 | 10 | 15 | 25 | 90 | 5 | B | A |
| Example 60 | 10 | KOH | 15 | 75 | 10 | 10 | 20 | 80 | 5 | B | A |
| Example 61 | 10 | KOH | 15 | 75 | 10 | 10 | 20 | 90 | 4 | A | A |
| Example 62 | 10 | KOH | 15 | 75 | 10 | 15 | 25 | 90 | 5 | B | A |
| Example 63 | 10 | KOH | 15 | 75 | 10 | 20 | 30 | 90 | 6 | C | A |
| Example 64 | 10 | KOH | 20 | 70 | 10 | 10 | 20 | 80 | 4 | A | A |
| Example 65 | 10 | KOH | 20 | 70 | 10 | 15 | 25 | 80 | 6 | C | A |
| Example 66 | 10 | KOH | 20 | 70 | 10 | 20 | 30 | 90 | 5 | B | A |
| Example 67 | 10 | KOH | 25 | 65 | 10 | 10 | 20 | 80 | 4 | A | A |
| Example 68 | 10 | KOH | 25 | 65 | 10 | 15 | 25 | 80 | 5 | B | A |
| Example 69 | 10 | KOH | 25 | 65 | 10 | 20 | 30 | 90 | 4 | A | A |
| Example 70 | 10 | KOH | 30 | 60 | 10 | 15 | 25 | 80 | 5 | B | A |
| Example 71 | 15 | KOH | 10 | 75 | 10 | 10 | 20 | 80 | 6 | C | A |
| Example 72 | 15 | KOH | 10 | 75 | 10 | 20 | 30 | 90 | 6 | C | A |
| Example 73 | 15 | KOH | 15 | 70 | 10 | 10 | 20 | 80 | 5 | B | A |
| Example 74 | 15 | KOH | 15 | 70 | 10 | 15 | 25 | 80 | 6 | C | A |
| Example 75 | 15 | KOH | 15 | 70 | 10 | 20 | 30 | 90 | 5 | B | A |
| Example 76 | 15 | KOH | 20 | 65 | 10 | 10 | 20 | 70 | 6 | C | A |
| Example 77 | 15 | KOH | 20 | 65 | 10 | 10 | 20 | 80 | 4 | A | A |
| Example 78 | 15 | KOH | 20 | 65 | 10 | 15 | 25 | 80 | 5 | B | A |
| Example 79 | 15 | KOH | 20 | 65 | 10 | 20 | 30 | 80 | 6 | C | A |
| Example 80 | 15 | KOH | 25 | 60 | 10 | 10 | 20 | 70 | 5 | B | A |
| Example 81 | 15 | KOH | 25 | 60 | 10 | 15 | 25 | 80 | 4 | A | A |
| Example 82 | 15 | KOH | 25 | 60 | 10 | 20 | 30 | 80 | 5 | B | A |
| Example 83 | 15 | KOH | 30 | 55 | 10 | 10 | 20 | 70 | 4 | A | A |
| Example 84 | 15 | KOH | 30 | 55 | 10 | 20 | 30 | 80 | 4 | A | A |
| Example 85 | 18 | KOH | 10 | 72 | 10 | 10 | 20 | 80 | 6 | C | A |
| Example 86 | 18 | KOH | 10 | 72 | 10 | 15 | 25 | 80 | 7 | C | A |
| Example 87 | 18 | KOH | 10 | 72 | 10 | 20 | 30 | 90 | 6 | C | A |
| Example 88 | 18 | KOH | 15 | 67 | 10 | 10 | 20 | 70 | 7 | C | A |
| Example 89 | 18 | KOH | 15 | 67 | 10 | 15 | 25 | 80 | 5 | B | A |
| Example 90 | 18 | KOH | 15 | 67 | 10 | 20 | 30 | 80 | 6 | C | A |
| Example 91 | 18 | KOH | 20 | 62 | 10 | 10 | 20 | 70 | 5 | B | A |
| Example 92 | 18 | KOH | 20 | 62 | 10 | 20 | 30 | 80 | 5 | B | A |
| Example 93 | 18 | KOH | 25 | 57 | 10 | 10 | 20 | 70 | 5 | B | A |
| Example 94 | 18 | KOH | 25 | 57 | 10 | 15 | 25 | 70 | 6 | C | A |
| Example 95 | 18 | KOH | 30 | 52 | 10 | 15 | 25 | 70 | 5 | B | A |
| Example 96 | 20 | KOH | 10 | 70 | 10 | 10 | 20 | 80 | 6 | C | A |
| Example 97 | 20 | KOH | 10 | 70 | 10 | 15 | 25 | 80 | 7 | C | A |
| Example 98 | 20 | KOH | 10 | 70 | 10 | 20 | 30 | 90 | 6 | C | A |
| Example 99 | 20 | KOH | 15 | 65 | 10 | 10 | 20 | 70 | 7 | C | A |
| Example 100 | 20 | KOH | 15 | 65 | 10 | 10 | 20 | 80 | 4 | A | A |
| Example 101 | 20 | KOH | 15 | 65 | 10 | 20 | 30 | 80 | 7 | C | A |
| Example 102 | 20 | KOH | 20 | 60 | 10 | 10 | 20 | 70 | 5 | B | A |
| Example 103 | 20 | KOH | 20 | 60 | 10 | 15 | 25 | 70 | 6 | C | A |
| Example 104 | 20 | KOH | 25 | 55 | 10 | 10 | 20 | 70 | 4 | A | A |
| Example 105 | 20 | KOH | 25 | 55 | 10 | 15 | 25 | 70 | 5 | B | A |
| Example 106 | 25 | KOH | 10 | 65 | 10 | 10 | 20 | 80 | 6 | C | A |
| Example 107 | 25 | KOH | 10 | 65 | 10 | 15 | 25 | 80 | 7 | C | A |
| Example 108 | 25 | KOH | 10 | 65 | 10 | 20 | 30 | 90 | 6 | C | A |
| Example 109 | 25 | KOH | 15 | 60 | 10 | 10 | 20 | 70 | 7 | C | A |
| Example 110 | 25 | KOH | 15 | 60 | 10 | 10 | 20 | 80 | 4 | A | A |
| Example 111 | 25 | KOH | 15 | 60 | 10 | 20 | 30 | 80 | 6 | C | A |
| Example 112 | 25 | KOH | 20 | 55 | 10 | 10 | 20 | 70 | 4 | A | A |
| Example 113 | 25 | KOH | 20 | 55 | 10 | 15 | 25 | 70 | 6 | C | A |
| Example 114 | 25 | KOH | 20 | 55 | 10 | 20 | 30 | 70 | 7 | C | A |
| Comparative Example 4 | Mixed acid (49 % hydrofluoric acid/70 % nitric acid = 1/8.5) | | | | 10 | 10 | 20 | 25 | 2 | A | B |
| Comparative Example 5 | 0 | KOH | 30 | 70 | 10 | 10 | 20 | 90 | 9 | D | A |
| Comparative Example 6 | 25 | - | 0 | 75 | 10 | 10 | 20 | 90 | >10 | D | B |

In the Examples in which etching with the etching liquid of the present invention was performed, excellent results were obtained in view of the evaluation of productivity such that the etching processing times were all from 4 to 7 minutes, and the evaluation of shape was also excellent. On the other hand, in Comparative Examples 1 and 4 using a mixed acid as the etching liquid, the processing times were short as 2 minutes, so the evaluation of productivity was good; however, the insulating layer and the connecting plug were dissolved, so a prescribed height was not obtained. Also, in Comparative Examples 2 and 5 using a hydroxylamine-free etching liquid, it took 9 minutes for the etching processing time, so the productivity was not sufficient; and in Comparative Examples 3 and 6 using an inorganic alkaline compound-free etching liquid, the etching processing could not be performed.

### INDUSTRIAL APPLICABILITY

The etching liquid of the present invention is able to be used for etching a silicon substrate rear surface in a through silicon via process, etch only a silicon substrate without etching a connecting plug composed of a metal such as copper, tungsten, etc., or polysilicon or the like, and exhibit an excellent etching rate. Also, when allowed to go through the through silicon via process, it is possible to manufacture a semiconductor chip for three-dimensional multi-chip semiconductor device having a through silicon via in excellent production efficiency.

## Claims

1. An etching liquid for etching a silicon substrate rear surface in a through silicon via process containing potassium hydroxide, hydroxylamine, and water.

2. The etching liquid according to claim 1, wherein a content of potassium hydroxide is from 10 to 50 % by mass, and a content of hydroxylamine is from 8 to 40 % by mass.

3. The etching liquid according to claim 1 or 2, wherein the silicon substrate has a redistribution layer and a connecting plug, and the connecting plug is protruded to the silicon substrate rear surface on which the redistribution layer is not provided.

4. The etching liquid according to claim 3, wherein the connecting plug is composed of at least one member selected from polysilicon, copper, and tungsten.

5. A method for manufacturing a semiconductor chip for three-dimensional multi-chip semiconductor device, which includes a silicon substrate rear surface etching step using the etching liquid according to any one of claims 1 to 4.

6. The method for manufacturing a semiconductor chip according to claim 5, wherein the silicon substrate rear surface etching step includes (1) a silicon substrate thinning step of thinning a silicon substrate in such a state that an insulating layer covering a connecting plug is coated on the silicon substrate and (2) a silicon substrate thinning step of protruding the connecting plug covered by the insulating layer in this order; and in at least the silicon substrate thinning step (2) , the etching liquid according to any one of claims 1 to 4 is used.

7. The method for manufacturing a semiconductor chip according to claim 6, wherein a total sum of a distance between the silicon substrate rear surface at the time of termination of the silicon substrate thinning step (1) and a surface of the insulating layer on the silicon substrate rear surface side and a distance between a surface of the insulating layer on the silicon substrate rear surface side at the time of termination of the silicon substrate thinning step (1) and the silicon substrate rear surface at the time of termination of the silicon substrate thinning step (2) falls within the range of from 20 to 30 µm.

8. The method for manufacturing a semiconductor chip according to claim 6 or 7, wherein the connecting plug is composed of at least one member selected from polysilicon, copper, and tungsten.

9. The method for manufacturing a semiconductor chip according to any one of claims 5 to 8, wherein the semiconductor chip is one used for three-dimensional multi-chip semiconductor devices.
